# EUROPEAN PATENT APPLICATION

(11) **EP 4 733 437 A1**
(43) Date of publication of application: **29.04.2026**
(21) Application number: 24209214.6
(22) Date of filing: 28.10.2024
(51) Int. Cl.: C23C 28/04, C23C 28/00, C23C 16/40, C23C 16/30, C23C 16/452, C23C 16/56, C23F 17/00, G01L 1/14, G01L 9/00, G01L 9/12, G01L 11/02, H01M 4/36, H01M 4/48, H01M 4/58

(54) **METAL FLUORIDE COATINGS**

(71) Applicant: Inficon AG, 9496 Balzers (LI)
(72) Inventor: BÜHLMANN, Kevin, 8880 Walenstadt (CH); ANDREAUS, Bernhard, 8640 Rapperswil (CH); MATA OSORO, Gustavo, 8600 Dübendorf (CH); SPRING, Philip, 9468 Sax (CH)
(74) Representative: Troesch Scheidegger Werner AG

(57) **Abstract**

The current invention relates to a solid coating comprising at least one layer of a metal oxide and at least one layer of a metal fluoride or metal oxyfluoride. The invention further pertains to a substrate coated with the present coating, to a use of the coating for protecting a substrate and to a method for coating a substrate with the instant coating, in particular for protecting the substrate against erosion, corrosion, oxidation or fluorination.

## Description

### TECHNICAL FIELD OF THE INVENTION

The current invention relates to a solid coating comprising at least one layer of a metal oxide and at least one layer of a metal fluoride or metal oxyfluoride. The invention further pertains to a substrate coated with the present coating, to a use of the coating for protecting a substrate and to a method for coating a substrate with the instant coating, in particular for protecting the substrate against erosion, corrosion, oxidation or fluorination.

### DESCRIPTION OF THE RELATED ART

Materials that are exposed to reactive chemical species, for example plasma-exposed materials, are prone to react with these chemical species in undesired ways. To avoid such reactions, the materials can be protected from reactive species by choosing resistant materials or by applying suitable coatings on the materials. While many different coatings are known in the art, it remains a challenge to protect materials against multiple different reactive species. Furthermore, coatings on materials can adversely alter the materials' properties or function, and these coatings may be difficult to apply.

### SUMMARY OF THE INVENTION

It is an objective of the present invention to provide means for protecting materials against reactive chemical species, in particular against oxidative, corrosive and/or fluorine-comprising environments.

This objective is solved by a solid multilayer arrangement with the features of claim 1.

In a first aspect, the present invention is directed to a solid multilayer arrangement comprising at least two layers in a layer stack, wherein
a first layer comprises a metal oxide or a metalloid oxide,
a second layer comprises a metal fluoride or metal oxyfluoride, and
the first and second layer are optionally in direct contact with each other.

It was surprisingly found that the solid multilayer arrangement of the present invention is suitable for protecting materials against reactions with oxygen (i.e. oxidation and corrosion) and fluorine, in particular fluorine radicals. Depending on the type of material, corrosion will lead to erosion of the material and these terms are used interchangeably. For example, the multilayer arrangement reduces or inhibits the diffusion of oxygen and thereby protects materials coated with the multilayer arrangement, e.g. from corrosion. Furthermore, the multilayer arrangement prevents reactions with fluorine (radicals) on materials coated with the multilayer arrangement.

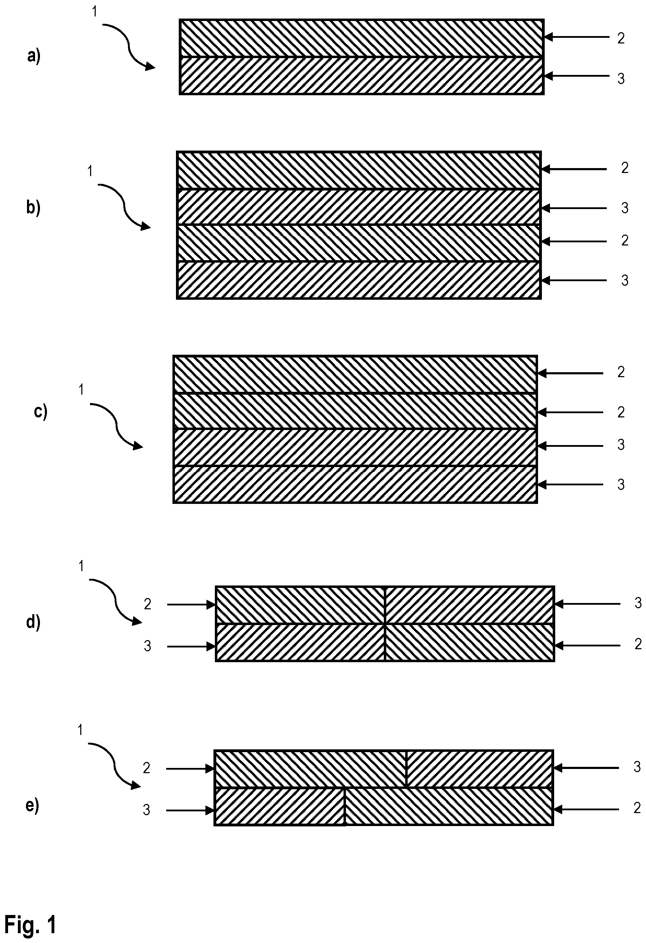

The multilayer arrangement comprises at least two layers in a layer stack which means that at least two layers (i.e. one first and one second layer) of the multilayer arrangement are positioned such that their largest surfaces face each other. For easier reading, this is termed "stacked on top of each other" (see Figure 1). Additionally, two layers (two first layers, two second layers or one first and one second layer) can be arranged such that their smallest surfaces face each other. For easier reading, this is termed "arranged next to each other" (see Figures 1 d) and e)). In both cases (stacked on top of each other or arranged next to each other), the layers can be in direct contact with each other, or they can be spaced apart from each other, wherein the space can be a void or optionally comprise further layers or other suitable materials. The multilayer can, for example, be positioned on a material in order to protect this material against reactions with oxygen and fluorine.

The order of the layers in the layer stack is not limited to any specific order in the present multilayer arrangement. Multiple first or second layers can be stacked on top of each other and optionally arranged next to each other. In an example, the first and second layers are alternatingly stacked on top of each other. In another example, the multilayer arrangement comprises one first and one second layer which are stacked on top of each other, optionally in direct contact with each other.

The term "layer" as used herein refers to a coherent layer or film of at least one molecule in thickness. Methods for manufacturing layers according to the present invention are known in the art and include, e.g., chemical vapor deposition (CVD), plasma enhanced CVD (PECVD), atomic layer deposition (ALD) and molecular layer deposition (MLD).

The term "in direct contact" as used herein includes the option that the layers can be attached to each other, e.g. adhere to each other, e.g. by means of chemical bonds. For example, the attachment can be achieved by the method of deposition, e.g. by ALD.

In an embodiment of the solid multilayer arrangement according to the present invention, which may be combined with any of the embodiments of the system preaddressed or still to be addressed unless in contradiction, the first and/or second layer, in particular the first layer, is/are amorphous. The presence of an amorphous layer in the multilayer arrangement helps to avoid the formation of cracks or grain boundaries between crystallites and thus further reduces the susceptibility of the multilayer arrangement to corrosion and erosion.

In an embodiment of the solid multilayer arrangement according to the present invention, which may be combined with any of the embodiments of the system preaddressed or still to be addressed unless in contradiction,
the metal oxide is an oxide of aluminum, yttrium, zirconium, hafnium or a combination thereof, and/or the metal fluoride or metal oxyfluoride is a fluoride or oxyfluoride of a rare-earth metal, of an alkaline earth metal or of a combination thereof, optionally of magnesium or calcium.

In an embodiment of the solid multilayer arrangement according to the present invention, which may be combined with any of the embodiments of the system preaddressed or still to be addressed unless in contradiction, the metal oxide is Al₂O₃, Y₂O₃, Y₃Al₅O₁₂, ZrO₂ or HfO₂, and/or the metal fluoride or oxyfluoride is MgF₂, CaF₂, YF₂C₂, YF₃, YbF3, LaF₃, LiF, YOF, AlOF, TiOF₂, or LaOF, including combinations thereof.

For example, the first layer can comprise a combination of Al₂O₃, Y₂O₃, ZrO₂, HfO₂ and/or Yttrium Aluminum Oxide, in particular Yttrium Aluminum Oxide with a molar ratio of Al:Y of 2:1, further in particular Y₃Al₅O₁₂, optionally wherein the different oxides form individual layers.

For example, the second layer can comprise a combination of MgF₂, CaF₂, MgF₂, CaF₂, YF₂C₂, YF₃, LaF₃, LiF, YOF, AlOF, TiOF₂, LaOF, FClO, FClO₂, F₃ClO, FClO₃, F₃CLO₂, FBrO₂, F₃BrO, FBrOs, FIO₂, F₃IO, FIO₃, F₃IO₂, and/or F₅IO, in particular MgF₂, CaF₂, YF₂C₂, YF, LaF₃, LiF, YOF, AlOF and/or TiOF₂, optionally wherein the different fluorides or oxyfluorides form individual layers.

In an embodiment of the solid multilayer arrangement according to the present invention, which may be combined with any of the embodiments of the system preaddressed or still to be addressed unless in contradiction, the thickness of the first layer is about 1 nm to 500 nm, optionally 150 nm to 300 nm or 200 nm to 250 nm, and/or the thickness of the second layer is about 1 nm to 500 nm, optionally 1 nm to 200 nm, optionally 5 nm to 60 nm, 30 nm to 50 nm or 30 nm to 60 nm.

For example, the solid multilayer arrangement can comprise or consist of two layers, wherein the first layer is made of a metal oxide, e.g. Al₂O₃, and has a thickness of about 150 to 300 nm or 200 nm to 250 nm, and the second layer is made of a metal fluoride, e.g. MgF₂, and has a thickness of about 30 to 50 nm or 30 nm to 60 nm, and wherein the first and second layer are in direct contact with each other. For example and for all aspects and embodiments disclosed herein, the first and the second layer may be stacked directly on top of each other, the first layer being in contact with a substrate and the second layer being exposed to a surrounding atmosphere.

For example, the solid multilayer arrangement can comprise a first layer of Al₂O₃, optionally having a thickness of 150 nm to 300 nm or 200 nm to 250 nm, and:
- a layer of Y₂O₃, optionally having a thickness of 10 to 15 nm,
- a layer of ZnO, optionally having a thickness of 10 to 15 nm,
- a layer of YF₃, optionally having a thickness of 10 to 30 nm,
- a layer of MgF₂, optionally having a thickness of 5 to 15 nm,
- one to four layer (s) each of Y₂O₃ and Al₂O₃, each optionally having a thickness of about 3 nm,
- one to four layer(s) each of YF₃ and Al₂O₃, each optionally having a thickness of about 5 nm, and/or
- one to four layer (s) each of MgF₂ and Al₂O₃, each optionally having a thickness of about 3 nm.

In all these examples, a first layer of Al₂O₃ may be the lowest layer in the layer stack and may have a larger thickness than further layers stacked on top of it.

Further objectives are achieved by a substrate with the features of claim 6.

In another aspect which may be combined with any of the embodiments or aspects preaddressed or still to be addressed unless in contradiction, the present invention is directed to a substrate coated, optionally at least partially coated, with the solid multilayer arrangement disclosed herein, wherein the first layer is optionally positioned closer to the substrate than the second layer, optionally wherein the substrate is in direct contact with the first layer; optionally wherein the substrate is a metallic, ceramic or silicate-comprising substrate, optionally an Al₂O₃- or borosilicate-comprising substrate, optionally, wherein the ceramic-comprising substrate is a sintered ceramic substrate, optionally a sintered Al₂O₃-comprising substrate.

For example, the substrate can be partially or fully coated with the solid multilayer arrangement as defined herein. The substrate may be, e.g., coated fully or partially on a surface of the substrate.

The term "coated" as used herein refers to a stable connection between the substrate (e.g. its surface) and the layers of the multilayer arrangement. The connection can be in the form of chemical bonds.

For example, the substrate or the surface of the substrate may be coated such that the first layer of the multilayer arrangement is in direct contact with, e.g. coated on, the substrate or surface thereof. The second layer may, in this example, be positioned such that it is in direct contact with the first layer. The second layer may, e.g., be exposed to the environment around the substrate.

In another aspect, which may be combined with any of the embodiments or aspects preaddressed or still to be addressed unless in contradiction, the present invention is directed to a substrate coated with a solid layer, wherein the solid layer comprises or consists of a metal fluoride or metal oxyfluoride (corresponding to the second layer as described herein). In other words, the substrate of this aspect is coated only with one or more solid layers of a metal fluoride or metal oxyfluoride, and not with a metal oxide layer.

In another aspect, which may be combined with any of the embodiments or aspects preaddressed or still to be addressed unless in contradiction, the present invention is directed to a substrate coated with a solid layer, wherein the solid layer comprises or consists of a metal fluoride or metal oxyfluoride as defined herein and a metal oxide within the same solid layer. In other words, the substrate of this aspect is coated with one or more solid layers comprising a mixture of a metal fluoride or metal oxyfluoride and a metal oxide as defined herein. The mixture of metal fluoride or oxyfluoride and metal oxide within this layer may be of any ratio between the metal fluoride, the metal oxyfluoride and/or the metal oxide, the ratio may be statistically or arbitrarily distributed within the layer, or there can be a concentration gradient within the layer, e.g. in that the concentration of the metal fluoride or oxyfluoride increases and the concentration of the metal oxide decreases within the layer away from the substrate, or towards the substrate that is coated with this layer.

All definitions provided above in the context of the first layer and the second layer, such as the type of metal fluoride, metal oxyfluoride, and/or metal oxide, the amorphous state, the thickness, the positioning and the adherence of the layer also apply mutatis mutandis to the aspects and embodiments in which the substrate is coated only with the metal fluoride or metal oxyfluoride layer and not with the metal oxide layer, and to the embodiment in which the substrate is coated with a layer comprising the metal fluoride or metal oxyfluoride and the metal oxide in one layer.

In all of the following aspects and embodiments, the aspect in which the substrate is coated (only) with the metal fluoride or with the metal oxyfluoride layer and not with the metal oxide layer, or in which the substrate is coated with a layer comprising a mixture of the metal fluoride and metal oxyfluoride within one layer, is also encompassed and specifically included even if not mentioned separately.

In an embodiment of the substrate coated with the solid layer or multilayer arrangement according to the present invention, which may be combined with any of the embodiments of the system preaddressed or still to be addressed unless in contradiction, the substrate is a metallic, ceramic or silicate-comprising substrate, optionally an Al₂O₃- or borosilicate-comprising substrate.

In an embodiment of the substrate coated with the solid layer or multilayer arrangement according to the present invention, which may be combined with any of the embodiments of the system preaddressed or still to be addressed unless in contradiction, the ceramic-comprising substrate is a sintered ceramic substrate, optionally a sintered Al₂O₃-comprising substrate.

For example, the substrate can be a metallic or ceramic membrane, e.g. of a capacitive diaphragm gauge, optionally being made of sintered Al₂O₃. It was surprisingly found that the multilayer arrangement according to all embodiments of the present invention can prevent the reaction of materials, e.g. of metals or ceramics, e.g. of Al₂O₃-based ceramics, with fluorine radicals, e.g. to form aluminum fluorides (e.g. AlF₃). The conversion of Al₂O₃ to 2 AlF₃ leads to a volume change (increase) which can lead to compressive stress within the ceramic material (membrane). If the ceramic material is, e.g., part of a pressure-sensitive membrane, the change in volume and concurrent compressive stress can deform the membrane and, thus, inadvertently affect pressure measurements. The combination of the first and second layer of the present solid multilayer arrangement can protect the membrane from reactions with fluorine while also providing protection against corrosion.

The inventors have recognized that the solid layer or multilayer arrangement on a membrane of a capacitive diaphragm gauge increases precision and long-term stability of pressure readings, in particular for pressure values at the low pressure end of the measuring range of a capacitive diaphragm gauge, such as e.g., in a range from 0 to 0.1 mbar.

In an embodiment of the substrate coated with the solid layer or multilayer arrangement according to the present invention, which may be combined with any of the embodiments of the system preaddressed or still to be addressed unless in contradiction, the substrate is a measuring surface of a sensor, optionally a sensor for measuring pressure, optionally a vacuum sensor, optionally a sensor selected from a capacitive diaphragm gauge (CDG), a Pirani gauge, an ionization vacuum gauge and an optical emission spectroscopy sensor. For example, the sensor can be a membrane that can be at least partially coated on the side that is exposed to the (processing) environment in which the pressure is measured. The sensor can be a heated or heatable wire of a pressure measuring device such as a Pirani gauge that is at least partially coated with the solid layer or multilayer arrangement at least where the wire is in contact with the (processing) environment in which the pressure is measured.

In an embodiment of the substrate coated with the solid layer or multilayer arrangement according to the present invention, which may be combined with any of the embodiments of the system preaddressed or still to be addressed unless in contradiction, the substrate is a metallic or ceramic membrane, optionally of a capacitive diaphragm gauge (CDG), or a conductive wire.

Further objectives are achieved by a sensor for measuring pressure and a capacitive diaphragm gauge with the features of claims 8 and 9.

In another aspect which may be combined with any of the embodiments or aspects preaddressed or still to be addressed unless in contradiction, the present invention is directed to a sensor, optionally a sensor for measuring pressure, optionally a vacuum sensor, optionally a sensor selected from a capacitive diaphragm gauge (CDG), a Pirani gauge, an ionization vacuum gauge and an optical emission spectroscopy sensor, comprising a measuring surface, optionally a membrane or a conductive wire, at least partially coated with the solid layer or multilayer arrangement as described herein.

In another aspect which may be combined with any of the embodiments or aspects preaddressed or still to be addressed unless in contradiction, the present invention is directed to a capacitive diaphragm gauge having a ceramic membrane, a housing, optionally a ceramic housing, and a silicate-based glass bond establishing a vacuum-tight bond between the ceramic membrane and the housing, wherein the ceramic membrane, the glass bond and the housing are at least partially coated with the solid layer or multilayer arrangement as defined herein.

The capacitive diaphragm gauge can be, e.g., a capacitive diaphragm pressure measuring cell as described in WO 2014/102035 (see, in particular cell (20) with membrane (2) in Fig. 1 and Figs. 2a-c).

The capacitive diaphragm gauge, as described herein, may, for example, be a diaphragm gauge that is used in or connected to a processing chamber, e.g. a processing chamber in which plasmas are present, e.g. corrosive plasmas and plasmas including fluorine radicals, e.g. NF₃ and CF₄ plasmas, or a processing chamber in which thermally activated HF or ClF₃ are present.

For example, the ceramic membrane and the silicate-based glass bond can be completely coated, the housing can be partially coated, e.g. in the areas that are exposed to plasmas, e.g. corrosive plasmas and plasmas including fluorine radicals, e.g. NF₃ and CF₄ plasmas, or exposed to thermally activated HF or ClF₃.

Further objectives are achieved by a use with the features of claim 10.

In another aspect which may be combined with any of the embodiments or aspects preaddressed or still to be addressed unless in contradiction, the present invention is directed to a use of the multilayer arrangement as described herein for protecting a substrate against erosion, corrosion, oxidation or fluorination, optionally for protecting a substrate against a chemical reaction with fluorine radicals.

For example, typically the surface of a substrate that is exposed to corrosion, oxidation or fluorination (e.g. fluorine radicals) is protected with the multilayer arrangement as described herein.

In an embodiment of the use according to the present invention, which may be combined with any of the embodiments of the use preaddressed or still to be addressed unless in contradiction, the substrate is a substrate as defined herein, and/or wherein the solid multilayer arrangement is for protecting against a chemical reaction with fluorine-comprising plasma, optionally an NF₃ and/or CF₄ plasma, or against thermally activated HF or ClF₃.

Further objectives are achieved by a method with the features of claim 12.

In another aspect which may be combined with any of the embodiments or aspects preaddressed or still to be addressed unless in contradiction, the present invention is directed to a method for coating a substrate with a solid multilayer arrangement as described herein, comprising the steps:
i. providing a substrate, optionally a substrate as described herein,
ii. coating the substrate with the first layer of the solid multilayer arrangement, optionally by atomic layer deposition,
iii. coating the first layer of step ii. with the second layer, optionally by atomic layer deposition, and
iv. optionally repeating steps ii. and iii., wherein the first and second layer are optionally coated alternatingly.

Further objectives are achieved by a method with the features of claim 13.

In another aspect which may be combined with any of the embodiments or aspects preaddressed or still to be addressed unless in contradiction, the present invention is directed to a coated substrate obtained or obtainable from the method for coating a substrate with a solid multilayer arrangement as described herein.

Further objectives are achieved by a method with the features of claim 14.

In another aspect which may be combined with any of the embodiments or aspects preaddressed or still to be addressed unless in contradiction, the present invention is directed to a method for protecting a substrate against erosion, corrosion, oxidation or fluorination, optionally for protecting a substrate against a chemical reaction with fluorine radicals, the method comprising the steps:
i. providing a substrate, optionally a substrate as described herein,
ii. coating the substrate with the first layer of the solid multilayer arrangement, optionally by atomic layer deposition,
iii. coating the first layer of step ii. with the second layer, optionally by atomic layer deposition, and
iv. optionally repeating steps ii. and iii., wherein the first and second layer are optionally coated alternatingly.

Suitable methods for coating are detailed above in the context of the method for manufacturing layers according to the present invention. For example, coating can be achieved on surfaces of devices in situ, i.e. as the surfaces to be covered are installed in a given device or system.

In an embodiment of the method for protecting a substrate against erosion, corrosion, oxidation or fluorination according to the present invention, which may be combined with any of the embodiments of the method preaddressed or still to be addressed unless in contradiction, the method further comprises the step:
v. exposing the coated substrate after step iv. to erosive, corrosive, or oxidative conditions.

Examples for erosive, corrosive, or oxidative conditions are provided above in the context of other aspects of the present invention.

In an embodiment of the method for protecting a substrate against erosion, corrosion, oxidation or fluorination according to the present invention, which may be combined with any of the embodiments of the method preaddressed or still to be addressed unless in contradiction, in step v., the coated substrate is exposed to an oxidation source, optionally oxygen, or fluorine radicals, optionally an NF₃ and/or CF₄ plasma, or thermally activated HF or ClF₃.

### BRIEF DESCRIPTION OF THE DRAWINGS

Embodiments of the current invention are described in more detail in the following with reference to the figures and examples. These are for illustrative purposes only and are not to be construed as limiting.
Figs. 1 a-e) depict exemplary solid multilayer arrangements;
Figs. 2 a-c) depict substrates coated with solid multilayer arrangements;
Fig. 3 depicts an exemplary capacitive diaphragm gauge having a membrane, coated with a solid multilayer arrangement;
Fig. 4 depicts a zoomed part of cross-section of an embodiment of a coated substrate; and
Fig. 5 depicts the drifting of measurement signals obtained from capacitive diaphragm gauges having differently coated ceramic membranes.

### DETAILED DESCRIPTION OF THE FIGURES

Figure 1 a) shows a sectional view of a solid multilayer arrangement (1) according to the present invention comprising a first layer (2) and a second layer (3). The first and second layer are arranged in a layer stack, i.e. they are positioned such that their largest surfaces face each other. This is termed "stacked on top of each other" herein. The first (2) and second layer (3) are in direct contact in this example, which means that they adhere to each other, for example by chemical bonds. The layers are depicted with the same thickness for illustrating purposes only. The thicknesses of the layers can vary in absolute and relative dimensions and the dimensions can be adjusted by the skilled person in accordance with the individual case. For example, the first and/or second layer can be of any thickness ranging from 1 to 500 nm, optionally from 2 to 100 nm. For example, the thickness of the first layer may be in the range from 30 to 200 nm, optionally 40 to 120 nm or 80 to 100 nm, and the second layer may have a thickness in the range from 2 to 50 nm, optionally 3 to 20 nm or 5 to 15 nm. In an example, the thickness of the first layer may is in the range from 80 to 100 nm and the thickness of the second layer is in the range from 5 to 15 nm.

Figures 1 b) and c) show sectional views of further solid multilayer arrangements (1) according to the present invention comprising two first layers (2) and two second layers (3). The first and second layers can be arranged alternatingly, or two or more first layers can be followed by two or more second layers in stacking direction (in direction top or bottom of the page).

Figure 1 d) and e) show sectional views of a solid multilayer arrangement (1) according to the present invention comprising two first layers (2) and two second layers (3), wherein one first and one second layer are arranged such that their smallest surfaces face each other, which is termed "arranged next to each other".

Additionally, a further first and further second layer are arranged such that their largest surfaces face the largest surface of the other first and second layers. The overlaps of the layers along their largest surfaces can vary in location as depicted in Figure 1 e).

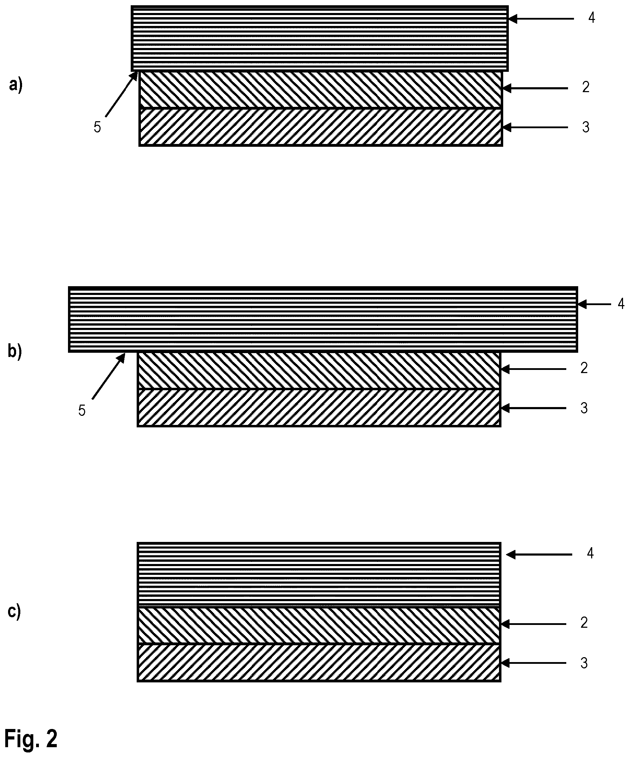

Figure 2 a) shows a sectional view of a substrate (4) coated with a solid multilayer arrangement according to the present invention comprising a first layer (2) and a second layer (3). In this example, the surface (5) of the substrate (4) is coated. In this example, the first layer (2) is in direct contact with the substrate's surface (5), e.g. by chemical bonds, and the second layer (3) is exposed to the environment. As shown in Figures 2 b) and c), the surface can be partially (Figure 2 b)) or complete (Figure 2 c)) coated. Any arrangement, number or thickness of the first and second layer can be coated on the substrate (4), e.g. as outlined in Figures 1 a) to e).

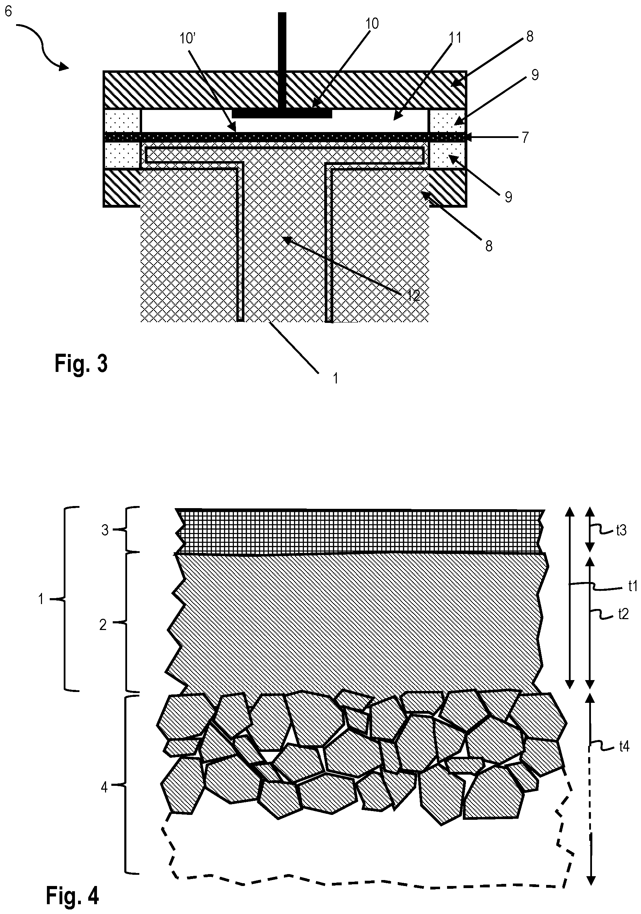

Figure 3 shows a sectional view of an exemplary capacitive diaphragm gauge (6) having a membrane (7), optionally a ceramic membrane, a housing (8), optionally a ceramic or metallic housing, and a bond (9), optionally a silicate-based glass bond establishing a vacuum-tight bond between the membrane and the housing. The gauge further comprises at least partially opposing capacitor electrodes (10) and (10'). The electrode (10') can be part of or coated on the membrane, and the electrode (10) can be coated on the surface of the housing (8). The gauge (6) can be a capacitive diaphragm pressure measuring cell as described in WO 2014/102035 (see, in particular cell (20) with membrane (2) in Fig. 1 and Figs. 2a-c therein). The gauge is open to or in fluid communication with the space in which a pressure is measured, e.g. a processing environment (bottom of the figure). At least part of the internal surfaces of the gauge (6) are coated with a solid multilayer arrangement (1) according to the present invention. For example, at least part of the surfaces of the gauge that are exposed to a process environment can be coated whereas the surfaces within the gauge that are not in contact with the process environment are not necessarily coated. In the example shown here, a space (11) with reference pressure is enclosed in a vacuum-tight way by the housing (9), the membrane (7) and the (glass-) bond (9). As implemented in the example shown in Figure 3, the surfaces exposed to this space (11) need not to be covered by the solid multilayer arrangement. On the opposite side of the membrane, there is the measuring space (12), which may become exposed to various process gases and plasmas during operation of the capacitive diaphragm gauge. The surface of the membrane facing towards the measuring space (12), as well as adjacent surfaces of the (glass-) bond (9) and of the housing, also facing towards the measuring space (12), are protected by a continuous coating formed of the solid multilayer arrangement (1) according to the invention. Although Figure 3 shows that all surfaces that are exposed to a process environment are coated, the area of coating can be varied, e.g. according to the materials of the surfaces. For example, the membrane (2) and the exposed surface of the bond (9) can be coated together with the housing (8), or each of these components can be coated individually.

In the simplified representation of Figure 3, the cross-section through the solid multilayer arrangement (1) as a whole is displayed with cross-hatching. No inner layer structure of the solid multilayer arrangement is visible here. The inner layer structure may be any one as discussed above or as displayed in Figure 1 or 2. In addition, the thickness of the solid multilayer arrangement is not to scale in relation to the dimensions of the capacitive diaphragm gauge. In particular, the solid multilayer arrangement may have a total thickness in the order of 100 nanometers, whereas a diameter of the membrane may be in the range of dozens of millimeters.

Figure 4 shows a zoomed part of a cross-section of an embodiment of a coated substrate. The vertical axis of the figure points in the direction of the thickness of the layer stack, i.e. perpendicular to the main extension of the layers, which main extension may be several magnitudes more than the thickness of the layers. In this example, the substrate 4 is composed of crystallites sintered together. The crystallites are symbolically indicated as polygons touching each other. A coating in form of a solid multilayer arrangement 1 covers the substrate. The solid multilayer arrangement in this example comprises exactly two layers, namely a first layer (2), which is in direct contact with the substrate (4), and a second layer (3), which is arranged on top of the first layer and forms a boundary to the environment of the coated substrate. The first layer and the substrate are composed of the same metal oxide or metalloid oxide, as symbolically indicated by the same diagonal hatching, however, the first layer is an amorphous layer, being free of crystallites. The substrate and the first layer may e.g., be composed of Al₂O₃. The first layer may to a certain degree level out an unevenness stemming from the crystallites of the substrate, but may still have a slightly uneven outer surface, as indicated by the slightly wavy upper boundary. The second layer, in this case consisting of an amorphous metal fluoride, e.g. of MgF₂, is in direct contact with the first layer and covers an upper side of the first layer completely.

A thickness (t1) of the solid layer stack may be in the order of 80 nm to 260 nm or 220 nm to 260nm, wherein the thickness (t2) of the first layer is about 3 to 10 times the thickness (t3) of the second layer. The thickness (t4) of the substrate without the coating may be significantly larger than the thickness (t1) of the solid layer stack, such that the distance to the lower boundary of the substrate, which is indicated by a dashed line, is not to scale with respect to the thickness of the layers of the solid layer stack. As a specific example, the thickness (t2) may be 80 nm or 200 nm and the thickness (t3) may be 15 nm or 50 nm, adding up to a total thickness t1 of the solid layer stack being 95 nm or 250 nm.

A coated substrate as shown in Fig. 4 may be used as membrane in a capacitive diaphragm gauge as shown in Fig. 3. The second layer (3), e.g., composed of amorphous MgF₂, may form the boundary facing towards the measuring space (12), i.e., it may at least form the boundary which may come into contact with an oxidation source or fluorine radicals, such as e.g., an NF₃ and/or CF₄ plasma.

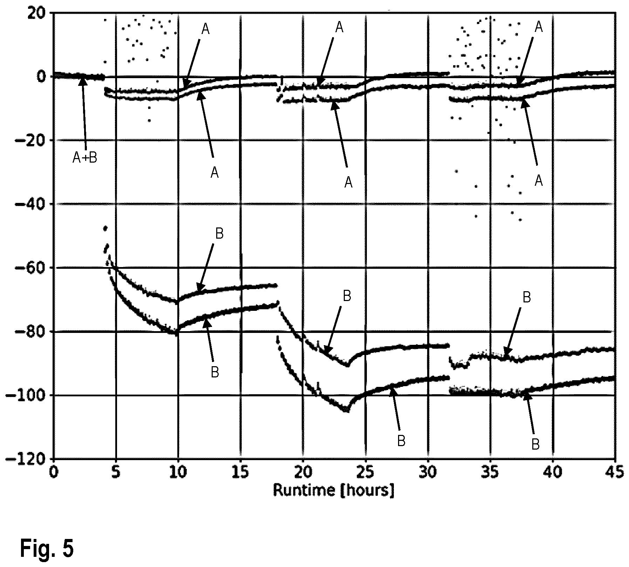

Figure 5 shows measurement signals (in arbitrary units on the y-axis, for example mV) of capacitive diaphragm gauges having ceramic membranes that were coated on the side exposed to the environment with (A) a first layer of Al₂O₃ (200 nm thickness, positioned on the ceramic membrane) and a second layer of MgF₂ (50 nm thickness, positioned on the first layer) and (B) only with 200 nm of Al₂O₃.

### EXAMPLES

The measurement signal (in mV) of a capacitive diaphragm gauge having a ceramic membrane that was coated on the side exposed to the environment in which the pressure was measured with a first layer of Al₂O₃ (200 nm thickness, positioned on the ceramic membrane) and a second layer of MgF₂ (50 nm thickness, positioned on the first layer) was monitored at a constant pressure during a period of 45 hours while the membrane was exposed to fluorine radicals on the coated side of the membrane. The measurement signal was compared to the signal generated by the same capacitive diaphragm gauge with a membrane only coated with 200 nm of Al₂O₃ under the same conditions as a control. After about 4 hours, it could be observed that the measurement signal of the control gauge (200 nm of Al₂O₃ coating only) drifted significantly, whereas the measurement signal of the gauge with the membrane coated with both Al₂O₃ and MgF₂ did not shift significantly (see Figure 5). Hence, the coating with both Al₂O₃ and MgF₂ protected the membrane from the fluorine radicals and enabled a stable signal over a period of at least 45 hours.

### LIST OF REFERENCE SIGNS

1 solid multilayer arrangement
2 first layer
3 second layer
4 substrate
5 surface of substrate
6 capacitive diaphragm gauge
7 membrane
8 housing
9 (glass) bond
10, 10' electrode
11 space with reference pressure
12 measuring space
t1 thickness of solid multilayer arrangement
t2 thickness of first layer
t3 thickness of second layer
t4 thickness of substrate (excluding the coating)

## Claims

1. A solid multilayer arrangement (1) comprising at least two layers in a layer stack, wherein
a first layer (2) comprises a metal oxide or a metalloid oxide,
a second layer (3) comprises a metal fluoride or metal oxyfluoride, and
the first and second layer are optionally in direct contact with each other.

2. The solid multilayer arrangement (1) according to claim 1, wherein
the first (2) and/or second (3) layer is/are amorphous; and/or
the metal oxide is an oxide of aluminum, yttrium, zirconium, hafnium or a combination thereof, and/or the metal fluoride or metal oxyfluoride is a fluoride or oxyfluoride of a rare-earth metal, of an alkaline earth metal or of a combination thereof, optionally of magnesium or calcium.

3. The solid multilayer arrangement (1) according to claim 1 or 2, wherein
the metal oxide is Al₂O₃, Y₂O₃, Y₃Al₅O₁₂, ZrO₂ or HfO₂; and/or
the metal fluoride or oxyfluoride is MgF₂, CaF₂, YF₂C₂, YF₃, YbF3, LaF₃, LiF, YOF, AlOF, TiOF₂, or LaOF, including combinations thereof.

4. The solid multilayer arrangement (1) according to any of claims 1 to 3, wherein
the thickness of the first layer (2) is about 1 nm to 500 nm, optionally 150 nm to 300 nm or 200 nm to 250 nm, and/or the thickness of the second layer (3) is about 1 nm to 500 nm, optionally 1 nm to 200 nm, optionally 5 nm to 60 nm or 30 nm to 50 nm.

5. A substrate (4) coated with the solid multilayer arrangement (1) according to any of claims 1 to 4, wherein the first layer (2) is optionally positioned closer to the substrate (4) than the second layer (3), optionally wherein the substrate (4) is in direct contact with the first layer (2);
optionally wherein the substrate (4) is a metallic, ceramic or silicate-comprising substrate, optionally an Al₂O₃- or borosilicate-comprising substrate, optionally, wherein the ceramic-comprising substrate is a sintered ceramic substrate, optionally a sintered Al₂O₃-comprising substrate.

6. The substrate (4) according to claim 5, wherein the substrate is a measuring surface of a sensor, optionally a sensor for measuring pressure, optionally a vacuum sensor, optionally a sensor selected from a capacitive diaphragm gauge (CDG), a Pirani gauge, an ionization vacuum gauge and an optical emission spectroscopy sensor.

7. The substrate (4) according to claim 5 or 6, wherein the substrate is a metallic or ceramic membrane, optionally of a capacitive diaphragm gauge (CDG), or a conductive wire.

8. A sensor, optionally a sensor for measuring pressure, optionally a vacuum sensor, optionally a sensor selected from a capacitive diaphragm gauge (CDG), a Pirani gauge, an ionization vacuum gauge and an optical emission spectroscopy sensor, comprising a measuring surface, optionally a membrane or a conductive wire, at least partially coated with the solid multilayer arrangement (1) according to any of claims 1 to 4.

9. A capacitive diaphragm gauge (6) having a ceramic membrane (7), a housing (8), optionally a ceramic housing, and a silicate-based glass bond (9) establishing a vacuum-tight bond between the ceramic membrane and the housing, wherein the ceramic membrane, the glass bond and the housing are at least partially coated with the solid multilayer arrangement (1) according to any of claims 1 to 4.

10. A use of the multilayer arrangement (1) according to any of claims 1 to 4 for protecting a substrate against erosion, corrosion, oxidation or fluorination, optionally for protecting a substrate against a chemical reaction with fluorine radicals.

11. The use according to claim 10, wherein the substrate (4) is a substrate according to any of claims 5 to 7, and/or wherein the solid multilayer arrangement (1) is for protecting against a chemical reaction with fluorine-comprising plasma, optionally an NF₃ and/or CF₄ plasma, or against thermally activated HF or ClF₃.

12. A method for coating a substrate (4) with a solid multilayer arrangement (1) according to any of claims 1 to 4, comprising the steps:
i. providing a substrate (4), optionally a substrate according to any of claims 5 to 7,
ii. coating the substrate (4) with the first layer (2) of the solid multilayer arrangement (1), optionally by atomic layer deposition,
iii. coating the first layer (2) of step ii. with the second layer (3), optionally by atomic layer deposition, and
iv. optionally repeating steps ii. and iii., wherein the first (2) and second layer (3) are optionally coated alternatingly.

13. A coated substrate (4) obtained or obtainable from the method according to claim 12.

14. A method for protecting a substrate (4) against erosion, corrosion, oxidation or fluorination, optionally for protecting a substrate against a chemical reaction with fluorine radicals, the method comprising the steps:
i. providing a substrate (4), optionally a substrate according to any of claims 5 to 7,
ii. coating the substrate (4) with the first layer of the solid multilayer arrangement (1), optionally by atomic layer deposition,
iii. coating the first layer (2) of step ii. with the second layer (3), optionally by atomic layer deposition, and
iv. optionally repeating steps ii. and iii., wherein the first (2) and second layer (3) are optionally coated alternatingly.

15. The method according to claim 14, wherein the method further comprises the step:
v. exposing the coated substrate (4) after step iv. to erosive, corrosive, or oxidative conditions, optionally to an oxidation source, optionally oxygen, or fluorine radicals, optionally an NF₃ and/or CF₄ plasma, or thermally activated HF or ClF₃.
